# EUROPEAN PATENT SPECIFICATION

(11) **EP 3 936 668 B1**
(45) Date of publication and mention of the grant of the patent: **11.09.2024**
(21) Application number: 21184130.9
(22) Date of filing: 06.07.2021
(51) Int. Cl.: E02B 3/14, H02S 20/20, B28B 19/00

(54) **EMBANKMENT ELEMENT AS WELL AS METHOD FOR ITS MANUFACTURE**
AUFSCHÜTTUNGSELEMENT SOWIE VERFAHREN ZU DESSEN HERSTELLUNG
ÉLÉMENT DE REMBLAI AINSI QUE SON PROCÉDÉ DE FABRICATION

(30) Priority: 06.07.2020 NL 2026009
(43) Date of publication of application: 12.01.2022
(73) Proprietor: Delmeco Vastgoed BV, 4462 HD Goes (NL)
(72) Inventor: ZWEMER, Jacobus Adriaan, 4493 EG Kamperland (NL)
(74) Representative: Verhees, Godefridus Josephus Maria

(56) References cited:
- JP-A- 2008 038 516
- JP-A- 2016 053 293
- KR-B1- 101 934 538
- US-A1- 2015 280 640
- US-A1- 2018 257 260

## Description

### Technical field of the invention

The invention relates to a method for manufacturing a flood barrier element having a body provided with a rear side with which the flood barrier element abuts against the flood defense during use 1and a water-facing front side, the flood barrier element comprises a solar panel provided with a sun-facing top side and a underside with which the solar panel is attached on the front side of the body in which method a solar panel is placed with the top on the bottom of a mold and an adhesive layer is applied to the underside of the solar panel, then concrete is poured into the mold on the underside of the solar panel, after which the concrete hardens to a concrete body.

### Background of the invention

A method according to the preamble of claim 1 is known from US2018/257260A1.

### Summary of the invention

An object of the invention is to improve the known method. To this end, the method according to the invention is characterized in that after applying the adhesive layer to the underside of the solar panel and before the concrete is poured on the underside of the solar panel, granular material is sprinkled on the adhesive layer that has not yet hardened, after which the concrete is poured on the underside of the solar panel, the flood barrier element comprises a solar panel provided with a top side facing the sun and an underside with which the solar panel is attached to the front side of the body. By applying the concrete in wet condition to the solar panel provided with granular material, an even better adhesion of the solar panel to the concrete body is obtained. Due to wave action, flood barrier elements are heavily loaded, so the use of solar panels on flood barrier elements is not an obvious choice. However, because flood barrier elements form a large surface area, they have nevertheless proved attractive for the use of solar panels, despite the higher requirements that the solar panels to be used have to meet.

The invention also relates to a flood barrier element for reinforcing/protecting a flood defense comprising a body made of concrete and provided with a rear side with which the flood barrier element abuts against the flood defense during use and a water-facing front side, the flood barrier element comprises a solar panel provided with a sun-facing top side and a underside with which the solar panel is attached on the front side of the body. This flood barrier element is characterized in that a granular material is attached to the underside of the solar panel and that the body is attached to the granular material and that the flood barrier element is made according to the above described method. By firmly attaching a granular material to the solar panel, a surface is obtained to which the concrete can adhere better than against the smooth underside of the solar panel. This makes it possible to obtain an attachment that can withstand the heavy load when applied to a flood defense.

The granular material is preferably made of stone, for example gravel, because concrete adheres to it well. The granular material is preferably glued to the underside of the solar panel. In this context, solar panel is understood to mean both a panel and a foil provided with photovoltaic cells.

An embodiment of the flood barrier element according to the invention is characterized in that through holes are present in the flood barrier element, which holes extend over the entire thickness of the flood barrier element in order to prevent the formation of underpressure under the flood barrier element.

A further embodiment of the flood barrier element according to the invention is characterized in that grooves are present in the rear side of the body for drainage of water present under the flood barrier element.

Yet another embodiment of the flood barrier element according to the invention is characterized in that the front side of the body is at an angle with respect to the rear side of the body and that this front side projects beyond the rear side on one side, wherein the beyond the rear side projecting part of the front forms a protruding ridge and the height of the sidewall below this ridge is the same as the height of the opposite sidewall. It is hereby possible that flood barrier elements present one after the other overlap each other with the ridges, so that water cannot get between the flood barrier elements and the underlying soil cannot wash away.

The invention further relates to a flood defense provided with a number of flood barrier elements, wherein, viewed in the tidal direction, rows of adjacent flood barrier elements are present one behind the other, wherein the flood barrier elements of a row present behind another row with their ridges facing the water are present on edges facing away from the water of the other row of flood barrier elements present in front of it.

### Brief description of the drawings

The invention will be further elucidated below on the basis of an exemplary embodiment of the flood barrier element and the method according to the invention shown in the drawings. Hereby shows:
Figure 1 shows a perspective view of a first embodiment of the flood barrier element according to the invention;
Figure 2 shows the mold containing the solar panel and concrete during the manufacture of the flood barrier element; and
Figure 3 shows a flood defense composed of a number of flood barrier elements according to a second embodiment of the invention.

### Detailed description of the drawings

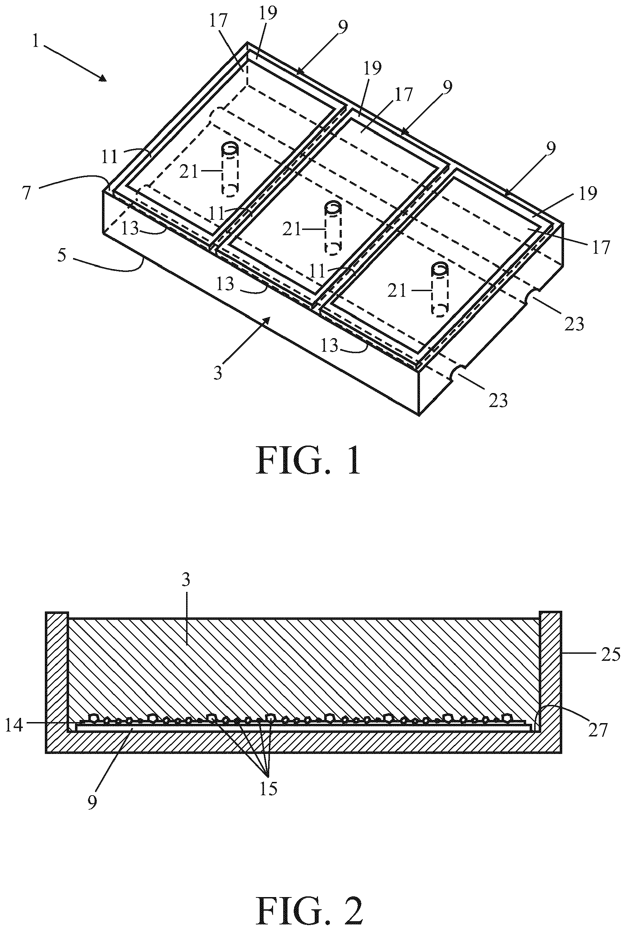

Figure 1 shows a perspective view of an embodiment of the flood barrier element according to the invention. The flood barrier element 1 is composed of a concrete plate 3 and a number of solar panels 9 mounted thereon. The concrete plate 3 is provided with a rear side 5 and a front side 7. During the presence of the flood barrier element against a flood defense, for instance a dike, the concrete plate lies with the rear side 5 against the dike and the front side 7 is facing the water.

Each solar panel 9 is provided with a top side 11 for receiving sunlight and an underside 13. The top side is made of a hard and wear-resistant material, for instance reinforced fiberglass. The solar panel 9 with its underside 13 is attached to the front side 7 of the concrete plate 3. Gravel 15 is glued to the underside 13 of the solar panel 9 and the concrete plate 3 is attached to the gravel 15 and the underside 13 of the solar panel 9. The solar panel 9 is constructed from a plastic carrier plate 19 and a plastic shielding plate 17 with photovoltaic cells in between.

In order to prevent the formation of underpressure under the flood barrier element during use, through-holes 21 are present in the flood barrier element 1, which holes extend over the entire thickness of the flood barrier element. Furthermore, grooves 23 are present in the rear side 5 of the concrete plate for drainage of water present under the flood barrier element.

The manufacturing process of the flood barrier element will be explained with reference to figure 2 . First of all, an adhesive layer 14 is applied to the underside 13 of a solar panel 9, after which granular material, for example gravel 15, is sprinkled on the adhesive layer 14 that has not yet hardened. The solar panel 9 is then placed with the top side 11 on the bottom 27 of a mold 25 . Subsequently, a layer of concrete is poured into the mold on the underside 13 of the solar panel 9. After the concrete has cured, the concrete plate 3 in which the gravel is embedded forms.

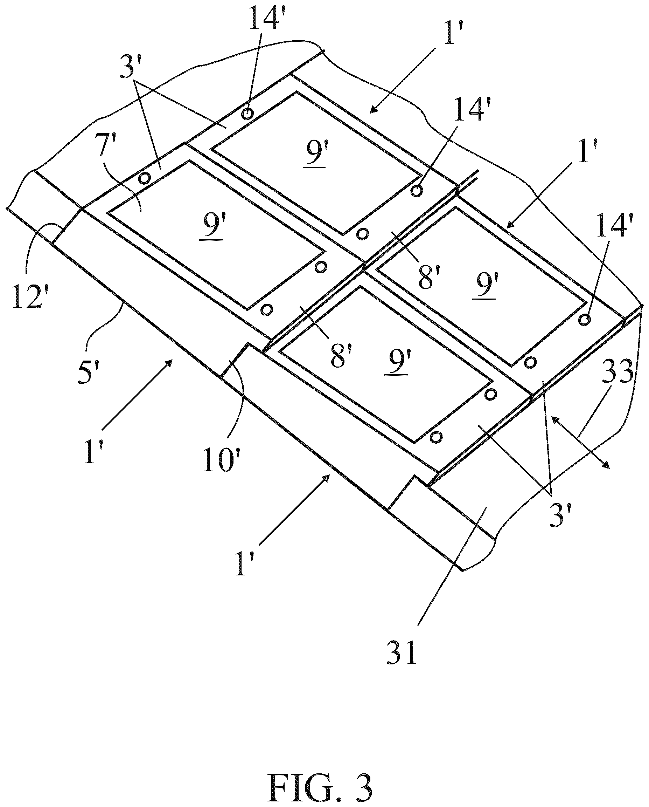

Figure 3 shows a flood defense in which, viewed in the tidal direction 33, rows of adjacent flood barrier elements 1' are present one behind the other on a dike 31. The flood barrier elements 1' of a row present behind another row have a ridge 8' facing the water that is present on an edge facing away from the water of flood barrier elements 1' of the other row in front of this row.

With these flood barrier elements 1', the front side 7' of the concrete body 3' is present at an angle with respect to the rear side 5' of the concrete body 3'. The front side 7' of the concrete body 3' protrudes on one end beyond the rear side 5', the part of the front side projecting beyond the rear side forming a projecting ridge 8'. The height of the side wall 10' below this ridge 8' is the same as the height of the opposite side wall 12', so that a further flood barrier element 1' with the side wall 12' can be placed under the ridge 8'.

The concrete elements are provided with electrical connections (not shown) to be able to electrically connect the solar panels 9' to each other. Furthermore, the concrete plates 3' are, in the front side, provide with bushings 14' with internal screw thread into which bolts provided with eyes can be turned for the purpose of lifting the flood barrier elements.

Although the invention has been elucidated in the foregoing with reference to the drawings, it should be noted that the invention is by no means limited to the embodiments shown in the drawings. The invention also extends to all embodiments deviating from the embodiments shown in the drawings within the framework defined by the claims.

## Claims

1. A method for manufacturing a flood barrier element (1; 1') having a body (3; 3') provided with a rear side (5; 5') with which the flood barrier element abuts against the flood defense during use and a water-facing front side (7; 7'), the flood barrier element comprises a solar panel (9) provided with a sun-facing top side (11) and a underside (13) with which the solar panel is attached on the front side (7; 7') of the body (3; 3'), in which method a solar panel (9) is placed with the top (11) on the bottom (27) of a mold (25) and an adhesive layer (14) is applied to the underside (13) of the solar panel (9), then concrete is poured into the mold on the underside (13) of the solar panel (9), after which the concrete hardens to a concrete body (3), **characterized in that** after applying the adhesive layer (14) to the underside (13) of the solar panel (9) and before the concrete is poured on the underside (13) of the solar panel (9), granular material (15) is sprinkled on the adhesive layer (14) that has not yet hardened, after which the concrete is poured on the underside (13) of the solar panel (9).

2. Flood barrier element (1; 1') for reinforcing/protecting a flood defense comprising a body (3; 3') made of concrete and provided with a rear side (5; 5') with which the flood barrier element abuts against the flood defense during use and a water-facing front side (7; 7'), the flood barrier element comprises a solar panel (9) provided with a sun-facing top side (11) and a underside (13) with which the solar panel is attached on the front side (7 ; 7') of the body (3; 3'), **characterized in that** a granular material (15) is attached to the underside (13) of the solar panel (9) and that the body (3; 3') is attached to the granular material (15) and that the floor barrier element (1, 1') is made according to the method of claim 1.

3. Flood barrier element (1; 1') according to claim 2, **characterized in that** the granular material (15) is made of stone.

4. Flood barrier element (1) according to any one of the preceding claims, **characterized in that** through holes (21) are present in the flood barrier element (1) which through holes (21) extend over the entire thickness of the flood barrier element in order to prevent the formation of underpressure under the flood barrier element.

5. Flood barrier element (1) according to any one of the preceding claims, **characterized in that** grooves (23) are present in the rear side (5) of the body (3) for drainage of water present under the flood barrier element (1).

6. Flood barrier element (1') according to claim 1, 2 or 3, **characterized in that** the front side (7') of the body (3') is at an angle to the rear side (5') of the body (3') and that this front side (7') projects on one side beyond the rear side (5'), whereby part of the front side protruding beyond the rear side forms a protruding ridge (8') and the height of the side wall (10 ') below this ridge (8') is equal to the height of the opposite side wall (12').

7. Flood defense comprising a number of flood barrier elements (1') according to claim 6, **characterized in that**, viewed in the tidal direction, rows of adjacent flood barrier elements (1') are present one behind the other, the flood barrier elements (1') of a row being behind another row with the ridges (8') facing the water are present on edges facing away from the water of flood barrier elements (1') of the other row in front of this row.

## Patentansprüche

1. Verfahren zur Herstellung eines Hochwasserschutzelements (1; 1') mit einem Körper (3; 3'), der mit einer Rückseite (5; 5'), mit der das Hochwasserschutzelement während des Gebrauchs an der Hochwasserabwehr anliegt, und einer dem Wasser zugewandten Vorderseite (7; 7') versehen ist, wobei das Hochwasserschutzelement ein Solarpanel (9) umfasst, das mit einer der Sonne zugewandten Oberseite (11) und einer Unterseite (13) versehen ist, mit der das Solarpanel an der Vorderseite (7; 7') des Körpers (3; 3') befestigt ist, bei welchem Verfahren ein Solarpanel (9) mit der Oberseite (11) auf den Boden (27) einer Form (25) gelegt und eine Klebeschicht (14) auf die Unterseite (13) des Solarpanels (9) aufgetragen wird, dann Beton in die Form auf die Unterseite (13) des Solarpanels (9) gegossen wird, wonach der Beton zu einem Betonkörper (3) aushärtet, **dadurch gekennzeichnet, dass** nach dem Auftragen der Klebeschicht (14) auf die Unterseite (13) des Solarpanels (9) und vor dem Aufgießen des Betons auf die Unterseite (13) des Solarpanels (9) körniges Material (15) auf die noch nicht ausgehärtete Klebeschicht (14) gestreut wird, wonach der Beton auf die Unterseite (13) des Solarpanels (9) gegossen wird.

2. Hochwasserschutzelement (1; 1') zur Verstärkung/zum Schutz eines Hochwasserschutzes, umfassend einen Körper (3; 3') aus Beton, der mit einer Rückseite (5; 5'), mit der das Hochwasserschutzelement während des Gebrauchs an dem Hochwasserschutz anliegt, und einer dem Wasser zugewandten Vorderseite (7; 7') versehen ist, wobei das Hochwasserschutzelement ein Solarpanel (9) umfasst, das mit einer der Sonne zugewandten Oberseite (11) und einer Unterseite (13) versehen ist, mit der das Solarpanel an der Vorderseite (7; 7') des Körpers (3; 3') befestigt ist, **dadurch gekennzeichnet, dass** ein körniges Material (15) an der Unterseite (13) des Solarpanels (9) befestigt ist und dass der Körper (3; 3') an dem körnigen Material (15) befestigt ist und dass das Hochwasserschutzelement (1; 1') gemäß dem Verfahren von Anspruch 1 hergestellt ist.

3. Hochwasserschutzelement (1; 1') gemäß Anspruch 2, **dadurch gekennzeichnet, dass** das körnige Material (15) aus Stein besteht.

4. Hochwasserschutzelement (1) nach einem der vorhergehenden Ansprüche, **dadurch gekennzeichnet, dass** im Hochwasserschutzelement (1) Durchgangslöcher (21) vorhanden sind, die sich über die gesamte Dicke des Hochwasserschutzelements erstrecken, um die Bildung eines Unterdrucks unter dem Hochwasserschutzelement zu verhindern.

5. Hochwasserschutzelement (1) nach einem der vorhergehenden Ansprüche, **dadurch gekennzeichnet, dass** in der Rückseite (5) des Körpers (3) Rillen (23) zum Abfließen von unter dem Hochwasserschutzelement (1) vorhandenem Wasser vorhanden sind.

6. Hochwasserschutzelement (1') nach Anspruch 1, 2 oder 3, **dadurch gekennzeichnet, dass** die Vorderseite (7') des Körpers (3') schräg zur Rückseite (5') des Körpers (3') verläuft und dass diese Vorderseite (7') einseitig über die Rückseite (5') hinausragt, wobei ein über die Rückseite hinausragender Teil der Vorderseite einen vorspringenden Grat (8') bildet und die Höhe der Seitenwand (10') unterhalb dieses Grates (8') gleich der Höhe der gegenüberliegenden Seitenwand (12') ist.

7. Hochwasserschutz umfassend einer Anzahl von Hochwasserschutzelementen (1') nach Anspruch 6, **dadurch gekennzeichnet, dass** in Gezeitenrichtung gesehen Reihen von nebeneinanderliegenden Hochwasserschutzelementen (1') hintereinander vorhanden sind, wobei die Hochwasserschutzelemente (1') einer Reihe hinter einer anderen Reihe liegen und die dem Wasser zugewandten Grate (8') an den dem Wasser abgewandten Kanten von Hochwasserschutzelementen (1') der anderen Reihe vor dieser Reihe liegen.

## Revendications

1. Procédé de fabrication d'un élément de barrière contre les inondations (1 ; 1') comportant un corps (3 ; 3') pourvu d'un côté arrière (5 ; 5') avec lequel l'élément de barrière contre les inondations vient en butée contre la protection contre les inondations pendant son utilisation et un côté avant (7 ; 7'), orienté vers l'eau l'élément de barrière contre les inondations comprend un panneau solaire (9) pourvu d'un côté supérieur orienté vers le soleil (11) et d'un côté inférieur (13) avec lequel le panneau solaire est fixé sur le côté avant (7 ; 7') du corps (3 ; 3'), procédé dans lequel un panneau solaire (9) est placé avec le dessus (11) sur le fond (27) d'un moule (25) et un adhésif une couche (14) est appliquée sur le côté inférieure (13) du panneau solaire (9), puis du béton est coulé dans le moule sur le côté inférieure (13) du panneau solaire (9), après quoi le béton durcit pour former un corps en béton (3), **caractérisé en ce qu'**après application de la couche adhésive (14) sur le côté inférieure (13) du panneau solaire (9) et avant que le béton ne soit coulé sur le côté inférieure (13) du panneau solaire (9), un matériau granulaire (15) est saupoudré sur la couche adhésive (14) non encore durcie, après quoi le béton est coulé sur le côté inférieure (13) du panneau solaire (9).

2. Elément de barrière contre les inondations (1 ; 1') pour renforcer/protéger une protection contre les inondations, comprenant un corps (3 ; 3') en béton et pourvu d'un côté arrière (5 ; 5') contre lequel l'élément de barrière contre les inondations vient en butée la protection contre les inondations pendant l'utilisation et un côté avant orientée vers l'eau (7 ; 7'), l'élément de barrière contre les inondations comprend un panneau solaire (9) pourvu d'un côté supérieure orientée vers le soleil (11) et d'un côté inférieure (13) avec laquelle le panneau solaire est fixé sur le côté avant (7 ; 7') du corps (3 ; 3'), **caractérisé en ce qu'**un matériau granulaire (15) est fixé sur le côté inférieure (13) du panneau solaire (9) et **en ce que** le corps (3 ; 3') est fixé au matériau granulaire (15) et **en ce que** l'élément de barrière contre les inondations (1 ; 1') est fabriqué selon le procédé de la revendication 1.

3. Elément de barrière contre les inondations (1 ; 1') selon la revendication 2, **caractérisé en ce que** le matériau granulaire (15) est en pierre.

4. Elément de barrière contre les inondations (1) selon l'une quelconque des revendications précédentes, **caractérisé en ce que** des trous traversants (21) sont présents dans l'élément de barrière contre les inondations (1) qui des trous traversants (21) s'étendent sur toute l'épaisseur de la barrière contre les inondations, élément de protection contre les inondations afin d'éviter la formation d'une dépression sous l'élément de barrière contre les inondations.

5. Elément de barrière contre les inondations (1) selon l'une quelconque des revendications précédentes, **caractérisé en ce que** des rainures (23) sont présentes dans le côté arrière (5) du corps (3) pour l'évacuation de l'eau présente sous l'élément de barrière contre les inondations (1).

6. Elément de barrière contre les inondations (1') selon la revendication 1, 2 ou 3, **caractérisé en ce que** le côté avant (7') de la carrosserie (3') forme un angle par rapport au côté arrière (5') de la carrosserie (3') et que cet côté avant (7') dépasse d'un côté au-delà de le côté arrière (5'), une partie de le côté avant dépassant du côté arrière formant une arête saillante (8') et la hauteur de la paroi latérale (10') en dessous de cette arête (8') est égale à la hauteur de la paroi latérale opposée (12').

7. Protection contre les inondations comprenant un certain nombre d'éléments de barrière contre les inondations (1') selon la revendication 6, **caractérisée en ce que**, vues dans le sens des marées, des rangées d'éléments de barrière contre les inondations adjacents (1') sont présentes les unes derrière les autres, la barrière contre les inondations des éléments (1') d'une rangée se trouvant derrière une autre rangée avec les arêtes (8') tournées vers l'eau sont présents sur les bords opposés à l'eau des éléments de barrière contre les inondations (1') de l'autre rangée devant cette rangée.
